# EUROPÄISCHE PATENTSCHRIFT

(11) **EP 3 371 835 B1**
(45) Veröffentlichungstag und Bekanntmachung des Hinweises auf die Patenterteilung: **28.02.2024**
(21) Anmeldenummer: 16778796.9
(22) Anmeldetag: 07.10.2016
(51) Int. Cl.: H01L 33/64, D01G 31/00, F21V 29/56

(54) **VORRICHTUNG ZUR FREMDTEILERKENNUNG IN DER SPINNEREIVORBEREITUNG**
DEVICE FOR IDENTIFYING FOREIGN PARTS DURING SPINNING PREPARATION
DISPOSITIF DE DÉTECTION DE CORPS ÉTRANGERS DANS LA PRÉPARATION DE FILATURE

(30) Priorität: 03.11.2015 DE 102015118848
(43) Veröffentlichungstag der Anmeldung: 12.09.2018
(73) Patentinhaber: Trützschler Group SE, 41199 Mönchengladbach (DE)
(72) Erfinder: ENGELS, Guido, 41569 Rommerskirchen (DE)
(86) Internationale Anmeldenummer: PCT/EP2016/073965
(87) Internationale Veröffentlichungsnummer: WO 2017/076573

(56) Entgegenhaltungen:
- DE-A1-102011 083 698
- DE-A1-102013 010 466
- DE-A1-102013 010 468
- GB-A- 2 300 480

## Beschreibung

Die vorliegende Erfindung betrifft eine Vorrichtung zur Fremdteilerkennung in der Spinnereivorbereitung, aufweisend einen Inspektionskanal, durch den ein Fasermaterialstrom hindurchführbar ist, wobei im Fasermaterialstrom zu erkennende Fremdteile vorhanden sind, wofür wenigstens eine Beleuchtungseinheit zur Einstrahlung von Licht in den Inspektionskanal vorgesehen ist, und wobei wenigstens eine Kamera vorgesehen ist, mit der von der Beleuchtungseinheit erzeugtes und von dem Fremdteil reflektiertes Licht detektierbar ist.

Die DE 10 2013 010 468 A1 offenbart eine Vorrichtung zur Fremdteilerkennung in der Spinnereivorbereitung mit einer Beleuchtungseinheit, die eine Vielzahl von Leuchtdioden in wenigstens mittelbarer Anordnung auf zumindest einer Platine aufweist und dazu eingerichtet ist, in einen Inspektionskanal der Vorrichtung einzustrahlen, durch den zu reinigendes Fasermaterial hindurchführbar ist. Zur Beleuchtung des Inspektionspunktes im Inspektionskanal werden zur Erzeugung großer Lichtintensitäten Beleuchtungseinheiten mit einer Vielzahl von Leuchtdioden eingesetzt, wobei beispielsweise eine Beleuchtungseinheit einige 100 bis zu 1.000 Leuchtdioden aufweisen kann, denen jeweils ein Optikkörper zugeordnet werden muss. Die Leuchtdioden werden segmentweise auf vorzugsweise mehreren Platinen angeordnet, und die Platinen werden aneinander gereiht und ergeben so eine Beleuchtungseinheit mit einer größeren Länge in einer Haupterstreckungsrichtung.

Als Träger für die Platinen mit den Leuchtdioden und den Optikkörpern dient ein Kühlkörper, der beispielsweise Kühlrippen aufweist, über die die Wärme mittels Konvektion abgeführt wird. Nachteilhafterweise ist eine Vorrichtung zur Fremdteilerkennung aufgrund der Einsatzumgebung einer hohen Staubbelastung ausgesetzt, sodass bei einer Kühlung der Beleuchtungseinheiten mittels Konvektion, die gegebenenfalls über Lüfter oder dergleichen unterstützt wird, die Beleuchtungseinheiten stark verunreinigen.

Zusätzlich zu den Beleuchtungseinheiten für eine Vorrichtung zur Fremdteilerkennung werden Kameras eingesetzt, um Fremdteile im Fasermaterialstrom zu erkennen und von beispielsweise den Baumwollflocken des Fasermaterialstroms zu trennen und auszusortieren. Das Aussortieren erfolgt mittels einer Ausführeinheit, mit der die Fremdteile in einen Sammelbehälter überführt werden. Aus dem Sammelbehälter werden die Fremdteile mit einer Absaugeinheit abgesaugt und zur Abscheidung in einen Filter geführt.

Beispielsweise zeigt hierzu die DE 10 2013 010 466 A1 eine Absaugeinheit, mit der die Fremdteile über eine Zellradschleuse in ein Saugrohr geführt werden und mittels eines Transportluftstromes über eine Luftleitung schließlich aus der Vorrichtung abgeführt werden. Dabei saugt die Absaugeinheit die Transportluft aus dem Vorrichtungsgehäuse an, wodurch Verunreinigungen besonders stark von der Außenseite in den Innenraum des Vorrichtungsgehäuses eingesaugt werden.

Die GB 2300480 A zeigt eine Vorrichtung in einer Spinnereivorbereitungseinrichtung zum Erkennen von Fremdstoffen, allerdings wird die Ausscheidung der Fremdstoffe mittels einer Schwenkklappe realisiert. Eine aktive Kühlung ist diesem Dokument nicht zu entnehmen.

Die DE 102013010468 A1 enthält zwar eine Anordnung von Beleuchtungselementen zur Inspektion eines Faserluftstroms, jedoch ist keine Kühlanordnung angegeben.

Die DE 102011083698 A1 wiederum zeigt eine flüssigkeitsgekühlt Beleuchtungseinrichtung, jedoch keine Anwendung in einer Spinnereivorbereitungsmaschine.

Aufgabe der Erfindung ist die Weiterbildung einer Vorrichtung zur Fremdteilerkennung in der Spinnereivorbereitung, die eine verbesserte Entwärmung der Beleuchtungseinheiten aufweist, und die zugleich eine verringerte Verunreinigung der Beleuchtungseinheiten ermöglicht. Dabei sollte die Staubbelastung der Beleuchtungseinheiten möglichst minimal sein, wobei zudem eine möglichst hinreichende Entwärmung der Leuchtdioden der Beleuchtungseinheiten aufrechterhalten bleibt. Mit weiterem Vorteil sollte der bauliche Aufwand möglichst reduziert werden.

Diese Aufgabe wird ausgehend von einer Vorrichtung zur Fremdteilerkennung in der Spinnereivorbereitung gemäß dem Oberbegriff des Anspruches 1 mit den erfindungsgemäßen Merkmalen gelöst. Vorteilhafte Weiterbildungen der Erfindung sind in den abhängigen Ansprüchen angegeben.

Die Erfindung sieht vor, dass ein geschlossenes Gehäuse vorgesehen ist, in dem die Beleuchtungseinheit luftdicht aufgenommen ist, und wobei eine Flüssigkeitskühleinheit zur Entwärmung der Beleuchtungseinheit vorgesehen ist, mit der im Betrieb der Beleuchtungseinheit entstehende Wärme mittels einer Flüssigkeit aus dem Gehäuse herausführbar ist.

Kern der Erfindung ist die Applikation einer Flüssigkeitskühlung zur Entwärmung der Beleuchtungseinheit bei gleichzeitiger Einrichtung eines Schutzes der Beleuchtungseinheit gegen Verunreinigungen. Das Gehäuse ist erfindungsgemäß geschlossen ausgeführt, so dass eine hermetisch dichte Kapselung der wenigstens einen Beleuchtungseinheit erzeugt ist, und wodurch das Eindringen von Verunreinigungen in den Innenraum des Gehäuses unterbunden wird. Im Ergebnis wird erreicht, dass die Beleuchtungseinheit auch bei einem längeren Betrieb der Vorrichtung nicht verunreinigt, insbesondere wird die Ablagerung von Staub auf der Beleuchtungseinheit vermieden. Damit wird wirkungsvoll einer frühzeitigen Alterung der Beleuchtungseinrichtung entgegengewirkt, wobei zugleich vermieden wird, dass das gesamte Vorrichtungsgehäuse dichtend abgeschlossen werden muss. Das geschlossene Gehäuse zur Aufnahme der wenigstens einen Beleuchtungseinheit bildet ein Gehäuse innerhalb des Vorrichtungsgehäuses der Vorrichtung, so dass die staubdichte Kapselung der Beleuchtungseinheit gemäß dem Gedanken der vorliegenden Erfindung nicht durch das Vorrichtungsgehäuse selbst erzeugt werden muss, da das geschlossene Gehäuse zur Aufnahme der Beleuchtungseinheit als zusätzliches Gehäuse vorgesehen wird.

Die geschlossene Ausführung des Gehäuses bezieht sich dabei auf einen unterbundenen Austausch von Luft von der Außenseite des Gehäuses zur Innenseite des Gehäuses. Das Gehäuse weist vorzugsweise Fensterscheiben auf, durch die die Kameras hindurchschauen können, um den Inspektionspunkt im Inspektionskanal zu erfassen. Da sich die Kameras i.d.R. hinterseitig zu den Beleuchtungseinheiten befinden, muss die Detektionsachse der Kameras durch das Gehäuse hindurchgelegt werden, wobei das Gehäuse mit weiterem Vorteil so ausgeführt sein kann, dass das Inspektionsfenster des Inspektionskanals durch eine vordere Fensterscheibe des Gehäuses selbst gebildet wird. Ein zum Fasermaterialstrom weisendes Fenster des Gehäuses kann dabei den Inspektionsteil des Inspektionskanals bilden, durch den die Beleuchtungseinheiten das Licht in den Inspektionskanal einstrahlen und durch den die Kameras in den Inspektionskanal schauen.

Gemäß einer vorteilhaften Weiterbildung der erfindungsgemäßen Vorrichtung weist die Flüssigkeitskühleinheit Flüssigkeitsleitungen auf, die durch eine Wandung des Gehäuses hindurchgeführt sind. Die Durchtrittsstellen der Flüssigkeitsleitungen durch die Wandung des Gehäuses sind dabei ebenfalls luftdicht ausgeführt und können Kupplungen umfassen, so dass die Flüssigkeitsleitungen bspw. von der Außenseite des Gehäuses gelöst werden können.

Die Beleuchtungseinheit weist mit besonderem Vorteil einen Kühl- und Aufnahmekörper auf, welcher mit Kühlkanälen versehen ist, durch die die Flüssigkeit der Flüssigkeitskühlung geführt wird. Ein weiterer Vorteil entsteht dadurch, dass der Kühl- und Aufnahmekörper kleiner ausgeführt werden kann als ein Kühlrippenkörper, da der Bauraum der Kühlrippen entfällt. Als Flüssigkeit der Flüssigkeitskühleinheit dient vorzugsweise Wasser.

Erfindungsgemäß weist die Flüssigkeitskühleinheit einen Wärmetauscher auf, mittels dem ein Wärmeübergang von der Flüssigkeit an eine den Wärmetauscher durchströmende Kühlluft erfolgt. Der Wärmetauscher ist dabei vorzugsweise beabstandet zur Beleuchtungseinheit und damit beabstandet zum geschlossenen Gehäuse innerhalb des Vorrichtungsgehäuses angeordnet. Die Flüssigkeitsleitungen sind mit einer entsprechenden Länge ausgeführt, so dass zur Bildung eines Kühlvorlaufes Flüssigkeitsleitungen mit abgekühlter Flüssigkeit vom Wärmetauscher in das geschlossene Gehäuse geführt sind, und es sind Flüssigkeitsleitungen vom geschlossenen Gehäuse zum Wärmetauscher ausgebildet, die die erwärmte Flüssigkeit von der Beleuchtungseinheit an den Wärmetauscher führen. Mit besonderem Vorteil wird der Wärmetauscher mit Kühlluft gekühlt, die von der Außenseite des Vorrichtungsgehäuses angesaugt wird. Die Umwälzung der der Flüssigkeit in den Flüssigkeitsleitungen erfolgt mittels einer Flüssigkeitspumpe, wobei als Flüssigkeitspuffer ein Flüssigkeitsspeicher vorgesehen ist.

Erfindungsgemäß ist eine Ausführeinheit vorgesehen, mit der die Fremdteile aus dem Fasermaterialstrom herausführbar sind, wobei weiterhin ein Sammelbehälter vorgesehen ist, in den die aus dem Fasermaterialstrom herausgeführten Fremdteile sammelbar sind. Um die im Sammelbehälter gesammelten Fremdteile aus diesem abzuführen, ist eine Absaugeinheit vorgesehen, mit der mittels einer Transportluft die Fremdteile aus dem Sammelbehälter abführbar sind. Der Sammelbehälter bildet jede Art eines Sammelraumes, aus dem mittels einer Zellradschleuse die Fremdteile abgeführt werden. Das Abführen der Fremdteile erfolgt mittels Unterdruck, der durch die Absaugeinheit erzeugt wird, wofür die Absaugeinheit ein Absauggebläse umfasst. In der Transportluft werden die Fremdteile in Schwebe gehalten und aus dem Saugrohr über eine Luftleitung herausgeführt.

Gemäß eines besonderen Vorteils der vorliegenden Erfindung werden die Kühlluft und die Transportluft zusammengeführt. Das Zusammenführen beider Luftströme erfolgt beispielsweise in einem Saugrohr unterhalb des Sammelbehälters, insbesondere nach der Zellradschleuse. Die Zellradschleuse verhindert dabei insbesondere das Einsaugen von Transportluft direkt aus dem Sammelbehälter, und das Saugrohr kann bspw. so ausgeführt sein, dass die Kühlluft in das Saugrohr mündet.

Mit besonderem Vorteil bildet die Kühlluft nach Durchströmen des Wärmetauschers die Transportluft. Mit anderen Worten ist der Wärmetauscher dem Saugrohr vorgelagert, und die Kühlluft wird vom Wärmetauscher unmittelbar in das Saugrohr eingesaugt, um die Fremdteile aufzunehmen. Damit bildet ein gemeinsamer Luftstrom zunächst die Kühlluft und anschließend die Transportluft.

Der gemeinsame Transportluftstrom der Transportluft und der Kühlluftstrom der Kühlluft wird durch das Absauggebläse gebildet, wobei das Absauggebläse stromabwärts hinter dem Saugrohr eingerichtet ist.

Schließlich weist die Absaugeinheit gemäß einer weiteren Ausgestaltung einen Filter auf, in den die Transportluft und die Kühlluft geführt sind und in den die Fremdteile aus den Luftströmen herausfilterbar sind. Der Filter bildet beispielsweise einen Gewebe-Schlauchfilter und ist vorzugsweise außerhalb des Vorrichtungsgehäuses angeordnet. Die erhöhte Temperatur der Transportluft durch die Zusammenführung mit der Kühlluft beeinflusst dabei den Abtransport der Fremdteile mittels der Transportluft nicht. Auch das Abscheiden der Fremdteile im Filter wird durch die erhöhte Temperatur des kombinierten Luftstroms nicht nachteilig beeinflusst.

Gemäß einer weiteren Ausgestaltung der erfindungsgemäßen Vorrichtung ist es denkbar, dass der Wärmetauscher und die Absaugeinheit als bauliche Einheit ausgeführt sind. Insbesondere kann der Wärmetauscher unmittelbar an das Saugrohr unterhalb des Sammelbehälters angrenzen, wobei das Saugrohr übergeht in eine Luftleitung, in oder an der das Absauggebläse angeordnet ist und die schließlich in den Filter der Vorrichtung mündet.

Mit Bezug auf die Anordnung der Beleuchtungseinheiten ist es von Vorteil, dass auf jeder Seite des Inspektionskanals zwei Beleuchtungseinheiten angeordnet sind, wobei auf jeder Seite die zwei Beleuchtungseinheiten in einem einzigen Gehäuse gemeinsam aufgenommen sind. Das Gehäuse umschließt dabei beide Beleuchtungseinheiten unter Bildung eines einzigen Hüllkörpers, wobei zwischen den beiden Beleuchtungseinheiten die Sichtachse der Kameras hindurchgeführt ist, so dass auf der Seite des Gehäuses, die zum Inspektionskanal weist, das Inspektionsfenster im Gehäuse eingebracht ist, und auf der gegenüberliegenden Rückseite des Gehäuses ist ein Kamera-Sichtfenster in das Gehäuse eingebracht.

Die Vorrichtung weist ein Vorrichtungsgehäuse auf, in dem zumindest abschnittsweise der Inspektionskanal, wenigstens ein Gehäuse mit der in diesem aufgenommenen Beleuchtungseinheit und wenigstens eine Kamera aufgenommen sind. Insbesondere ist der Filter außerhalb des Vorrichtungsgehäuses angeordnet, so dass die Luftleitung zur Führung sowohl des Kühlluftstromes als auch des Transportluftstromes aus dem Vorrichtungsgehäuse herausgeführt ist und in den Filter mündet.

Weitere, die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Figur 1: eine Ansicht einer Vorrichtung zur Fremdteilerkennung gemäß dem Stand der Technik,
- Figur 2: eine Gesamtansicht der Vorrichtung,
- Figur 3: eine Detailansicht des Wärmetauschers und der Absaugeinheit und
- Figur 4: die Detailansicht gemäß Figur 3, wobei ein Luftführungselement vorgesehen ist.

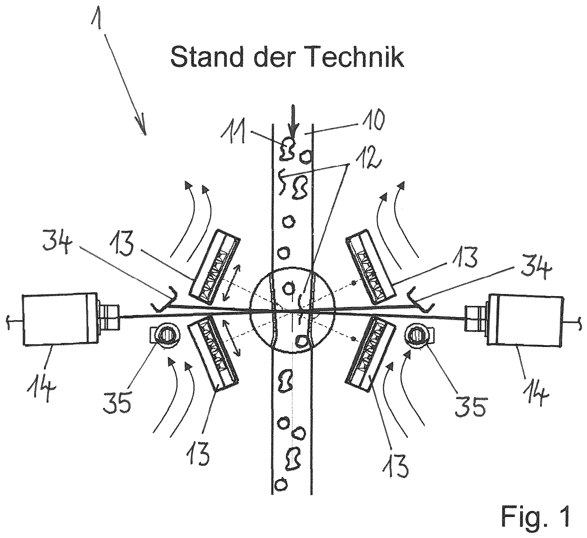

Figur 1 zeigt in einer schematischen Darstellung die Vorrichtung 1 zur Fremdteilerkennung in der Spinnereivorbereitung gemäß dem Stand der Technik. Die Vorrichtung 1 ist an einem Inspektionskanal 10 angeordnet, und durch den Inspektionskanal 10 wird in einer Längsrichtung gemäß dem gezeigten Richtungspfeil ein Fasermaterialstrom 11 hindurchgeleitet, der beispielsweise aus Baumwollflocken besteht. Zusätzlich zu den Baumwollflocken befindet sich im Fasermaterialstrom 11 ein Anteil von Fremdteilen 12, welcher von der Vorrichtung 1 detektiert werden kann.

Hierfür weist die Vorrichtung 1 zwei erste Beleuchtungseinheiten 13 auf einer ersten Seite des Inspektionskanals 10 auf, und es sind zwei weitere Beleuchtungseinheiten 13 auf der gegenüberliegenden zweiten Seite des Inspektionskanals 10 angeordnet. Mit den Beleuchtungseinheiten 13 auf der ersten Seite des Inspektionskanals 10 wird Licht von einer ersten Seite in den Inspektionskanal 10 eingestrahlt, und mit den zweiten Beleuchtungseinheiten 14 wird Licht von der gegenüberliegenden zweiten Seite in den Inspektionskanal 10 eingestrahlt. Auf jeder der beiden Seiten befindet sich eine Kamera 14, welche das eingestrahlte und an dem Fasermaterial 11 und insbesondere an den Fremdteilen 12 reflektierte Licht erkennen und analysieren können. Um eine definierte Hintergrundfarbe zu erzeugen, sind Hintergrundelemente 34 vorgesehen, die sich in Hauptachsenrichtung der Sichtachse der Kamera 14 auf der jeweils gegenüberliegenden Seite des Inspektionskanals 10 befinden und mit Hintergrundbeleuchtungen 35 insbesondere mit weißem Licht ausgeleuchtet sind. Die Hintergrundbeleuchtung 35 weist beispielsweise Leuchtstoffröhren auf, welche weißes, unpolarisiertes Licht im sichtbaren Wellenlängenbereich bereitstellen und die Hintergrundelemente 34 ausleuchten.

Die Beleuchtungseinheiten 13 umfassen eine Vielzahl von Leuchtdioden, die aufgrund der hohen zu erbringenden Lichtleistung gekühlt werden müssen, insbesondere um die Lebensdauer der Leuchtdioden nicht nachhaltig zu verringern. Die Kühlung erfolgt dabei auf bekannte Weise mittels Konvektion, wie mit mehreren Konvektionspfeilen dargestellt. Um die Konvektionskühlung der Beleuchtungseinheiten 13 zu ermöglichen, sind diese im Vorrichtungsgehäuse frei montiert und können beispielsweise Kühlrippenkörper aufweisen, an denen die Leuchtdioden montiert sind und an denen die Konvektion für den Wärmeübergang stattfindet.

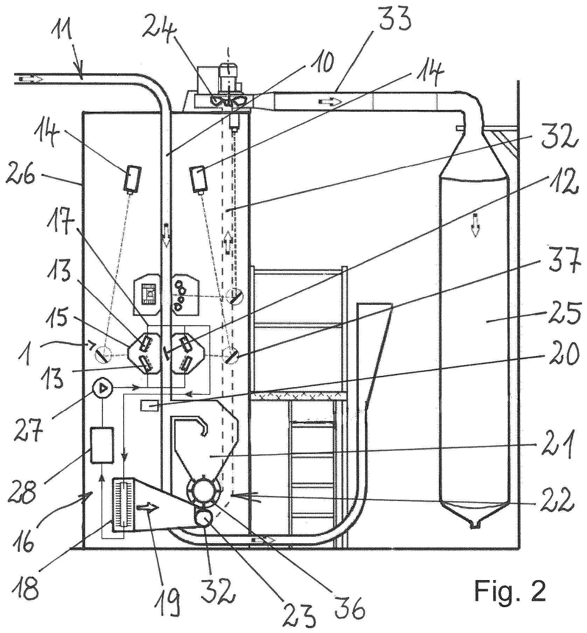

Figur 2 zeigt die Vorrichtung 1 in Anordnung in einem Vorrichtungsgehäus 26, wobei weitere, periphere Einrichtungen zum Betrieb der Vorrichtung 1 zur Fremdteilerkennung in der Spinnereivorbereitung dargestellt sind.

Die Vorrichtung 1 ist mit dem Inspektionskanal 10 gezeigt, durch den der Fasermaterialstrom 11 geführt ist. Auf jeder Seite des Inspektionskanals 10 befinden sich zwei Beleuchtungseinheiten 13, und jeweils zwei Beleuchtungseinheiten 13 auf jeder Seite des Inspektionskanals 10 sind in einem gemeinsamen Gehäuse 15 hermetisch dicht aufgenommen. Mittels Umlenkspiegeln 37 schauen die beiden Kameras 14 auf jeder der beiden Seiten des Inspektionskanals 10 durch das Gehäuse 15 hindurch in den Inspektionskanal 10. Die Funktion der Vorrichtung 1 entspricht dabei beispielsweise der Funktion der Vorrichtung 1, wie in Zusammenhang mit Figur 1 bereits beschrieben.

Oberhalb der dargestellten Vorrichtung 1 befindet sich eine weitere Inspektionseinheit, auf die im Zusammenhang mit der vorliegenden Beschreibung nicht näher eingegangen wird.

Unterhalb der Vorrichtung 1 befindet sich eine Ausführeinheit 20 zur Aussortierung von mittels der Vorrichtung 1 erkannten Fremdteilen 12. Die Ausführeinheit 20 ist beispielsweise als Düsenbalken ausgebildet, und die Fremdteile 12 können über Druckpulse aus dem Fasermaterialstrom 11 in den Sammelbehälter 21 überführt werden. Im Bodenbereich des Sammelbehälters 21 befindet sich eine Zellradschleuse 36, und unterhalb der Zellradschleuse 36 ist ein Saugrohr 32 angeordnet. Mittels der Zellradschleuse 36 werden die Fremdteile 12 in das Saugrohr 32 befördert, und mittels eines Absauggebläses 24 wird im Saugrohr 32 ein Unterdruck erzeugt, und die Fremdteile 12 werden über das weitere aufsteigende Saugrohr 32 vorbei am Absauggebläse 24 in eine Luftleitung 23 überführt. Die Luftleitung 23 mündet in einen Filter 25, in dem die Fremdteile 12 folglich abgeschieden werden. Die Zellradschleuse 36 dient dazu, dass der Saugstrom der Transportluft 23 nicht aus dem Sammelbehälter 21 gesaugt wird.

Die mit den aufgeführten Komponenten gebildete Absaugeinheit 22 dient folglich zur Abführung der Fremdteile 12 aus dem unteren Bereich der Zellradschleuse 36 über das Saugrohr 32 und die Luftleitung 33 in den Filter 25. Hierfür wird im Saugrohr 32 ein Luftstrom aus einer Transportluft 23 gebildet, mit dem die Fremdteile 12 mitgerissen werden. Gelangen die Fremdteile 12 in den Filter 25, so werden diese aus der Transportluft 23 abgeschieden.

Zur Kühlung der Beleuchtungseinheiten 13 dient eine Flüssigkeitskühleinheit 16. Die Flüssigkeitskühleinheit 16 weist Flüssigkeitsleitungen 17 auf, die durch die Wandung des Gehäuses 15 geführt sind, und mit der Flüssigkeit in den Flüssigkeitsleitungen 17 werden die Beleuchtungseinheiten 13 durchströmt und somit gekühlt. Wärme, die im Betrieb der Beleuchtungseinheiten 13 entsteht, wird an die Kühlflüssigkeit abgegeben, und die Flüssigkeitskühleinheit 16 weist einen Wärmetauscher 18 auf, in den die Flüssigkeitsleitungen 17 geführt sind. Zur Umwälzung der Flüssigkeit, beispielsweise gebildet durch Wasser, dient eine Flüssigkeitspumpe 27, an die angrenzend ein Flüssigkeitsspeicher 28 beispielhaft dargestellt ist.

Um die Wärme aus der Flüssigkeit herauszuführen, wird der Wärmetauscher 18 mit Kühlluft 19 durchströmt. Die Kühlluft 19 wird dabei in das Saugrohr 32 geführt bzw. in dieses eingesaugt, so dass beispielsweise außerhalb des Vorrichtungsgehäuses 26 angesaugte Luft den Wärmetauscher 18 durchströmt und damit die Kühlluft 19 bildet. Die Kühlluft 19 wird in das Saugrohr 32 geführt und bildet sodann die Transportluft 23. Über das Absauggebläse 24 wird folglich zunächst die Kühlluft 19 durch den Wärmetauscher 18 geführt und anschließend wird die Kühlluft 19 zur Transportluft 23, und führt aus dem Saugrohr 32 die Fremdteile 12 ab. Der somit gebildete gemeinsame Luftstrom gelangt folgend durch die Luftleitung 23 in den Filter 25, in den die Fremdteile 12 abgeschieden werden.

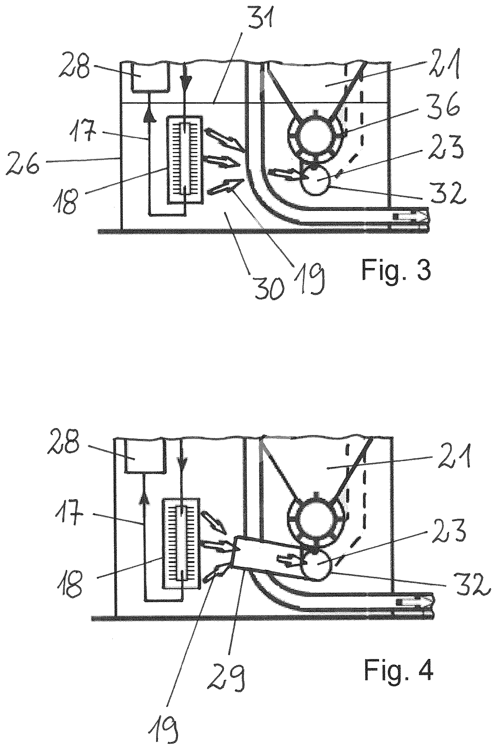

Figur 3 zeigt eine Detailansicht des Wärmetauschers 18 angrenzend an das Saugrohr 32 und den Sammelbehälter 21. Der Wärmetauscher 18 wird mit der Kühlflüssigkeit über die Flüssigkeitsleitungen 17 durchströmt, wobei an eine Flüssigkeitsleitung 17 ein Flüssigkeitsspeicher 28 angrenzend gezeigt ist. Nach Durchströmen des Wärmetauschers 18 bildet sich die erwärmte Kühlluft 19, die in Richtung zum Saugrohr 32 strömt. Um ein Durchströmen des Wärmetauschers 18 zu erreichen, und um anschließend die erwärmte Kühlluft 19 dem Saugrohr 32 zuzuführen, und durch das die Transportluft 23 geführt ist, ist ein Teil des Vorrichtungsgehäuses 26 mittels einer Trennwand 31 abgetrennt. In nicht näher gezeigter Weise kann die Kühlluft, die zunächst in den Wärmetauscher 18 gelangt, von der Außenseite des Vorrichtungsgehäuses 26 angesaugt werden. Durch den mit der Trennwand 31 separat abgetrennten Saugraum 30 entsteht der Vorteil, dass oberhalb des Saugraums 30 die Vorrichtung 1 nicht mit Kühlluft 19 und/oder Transportluft 23 durchströmt wird, beispielsweise um ferner die Kameras 14 vor Verunreinigungen zu schützen.

Über die Zellradschleuse 36 wird eine Abfuhr der Fremdteile 12 erreicht, wobei die Fremdteile 12 mittels der erwärmten Kühlluft 19 innerhalb des Saugrohrs 32 mit dem sodann gebildeten Transportluftstrom der Transportluft 23 mitgerissen werden.

Figur 4 zeigt eine abgewandelte Ausführungsform zur Führung der Kühlluft 19 in das Saugrohr 32. Die am Wärmetauscher 18 erwärmte Kühlluft 19 wird nach Eintritt in ein Luftführungselement 29 in das Saugrohr 32 geführt. Das Luftführungselement 29 kann sich dabei an ein offenes Ende des Saugrohres 32 anschließen, so dass die über die Flüssigkeitsleitung 17 eingebrachte Wärme in den Wärmetauscher 18 über die Kühlluft 19 und schließlich über die Transportluft 23 abgeführt werden kann.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht.

Sämtliche aus den Ansprüchen, der Beschreibung oder den Zeichnungen hervorgehenden Merkmale und/oder Vorteile, einschließlich konstruktiver Einzelheiten oder räumlicher Anordnungen, können sowohl für sich als auch in den verschiedensten Kombinationen erfindungswesentlich sein.

### Bezugszeichen

- 1: Vorrichtung

- 10: Inspektionskanal
- 11: Fasermaterialstrom
- 12: Fremdteil
- 13: Beleuchtungseinheit
- 14: Kamera
- 15: Gehäuse
- 16: Flüssigkeitskühleinheit
- 17: Flüssigkeitsleitung
- 18: Wärmetauscher
- 19: Kühlluft
- 20: Ausführeinheit
- 21: Sammelbehälter
- 22: Absaugeinheit
- 23: Transportluft
- 24: Absauggebläse
- 25: Filter
- 26: Vorrichtungsgehäuse
- 27: Flüssigkeitspumpe
- 28: Flüssigkeitsspeicher
- 29: Luftführungselement
- 30: Saugraum
- 31: Trennwand
- 32: Saugrohr
- 33: Luftleitung
- 34: Hintergrundelement
- 35: Hintergrundbeleuchtung
- 36: Zellradschleuse
- 37: Umlenkspiegel

## Patentansprüche

1. Vorrichtung (1) zur Fremdteilerkennung in der Spinnereivorbereitung, aufweisend einen Inspektionskanal (10), durch den ein Fasermaterialstrom (11) hindurchführbar ist, wobei
• im Fasermaterialstrom (11) zu erkennende Fremdteile (12) vorhanden sind, wofür wenigstens eine Beleuchtungseinheit (13) zur Einstrahlung von Licht in den Inspektionskanal (10) vorgesehen ist,
• wenigstens eine Kamera (14) vorgesehen ist, mit der von der Beleuchtungseinheit (13) erzeugtes und von dem Fremdteil (12) reflektiertes Licht detektierbar ist,
• ein geschlossenes Gehäuse (15) vorgesehen ist, in dem die Beleuchtungseinheit (13) luftdicht aufgenommen ist,
• eine Flüssigkeitskühleinheit (16) zur Entwärmung der Beleuchtungseinheit (13) vorgesehen ist,
- mit der im Betrieb der Beleuchtungseinheit (13) entstehende Wärme mittels einer Flüssigkeit aus dem Gehäuse (15) herausführbar ist und
- die einen Wärmetauscher (18) aufweist, mittels dem ein Wärmeübergang von der Flüssigkeit an eine den Wärmetauscher (18) durchströmende Kühlluft (19) erfolgt,
• eine Ausführeinheit (20) vorgesehen ist, mit der die Fremdteile (12) aus dem Fasermaterialstrom (11) herausführbar sind,
• ein Sammelbehälter (21) vorgesehen ist, in dem die aus dem Fasermaterialstrom (11) herausgeführten Fremdteile (12) sammelbar sind,
• eine Absaugeinheit (22) vorgesehen ist, mit der mittels einer Transportluft (23) die Fremdteile (12) aus dem Sammelbehälter (21) abführbar sind und
• die Kühlluft (19) und die Transportluft (23) zusammengeführt sind oder die Kühlluft (19) nach Durchströmen des Wärmetauschers (18) die Transportluft (23) bildet.

2. Vorrichtung (1) nach Anspruch 1, wobei die Flüssigkeitskühleinheit (16) Flüssigkeitsleitungen (17) aufweist, die durch eine Wandung des Gehäuse (15) hindurchgeführt sind.

3. Vorrichtung (1) nach Anspruch 1 oder 2, wobei die Absaugeinheit (22) ein Absauggebläse (24) aufweist, das einen Transportluftstrom der Transportluft (23) und einen Kühlluftstrom der Kühlluft (19) erzeugt.

4. Vorrichtung (1) nach einem der vorhergehenden Ansprüche, wobei die Absaugeinheit (22) einen Filter (25) aufweist,
• in den die Transportluft (23) und die Kühlluft (19) geführt sind und
• in dem die Fremdteile (12) aus den Luftströmen herausfilterbar sind.

5. Vorrichtung (1) nach einem der vorhergehenden Ansprüche, wobei der Wärmetauscher (18) und die Absaugeinheit (22) als bauliche Einheit ausgeführt sind.

6. Vorrichtung (1) nach einem der vorhergehenden Ansprüche, wobei
• auf jeder Seite des Inspektionskanals (10) zwei Beleuchtungseinheiten (13) angeordnet sind und
• auf jeder Seite die zwei Beleuchtungseinheiten (13) in einem einzigen Gehäuse (15) gemeinsam aufgenommen sind.

7. Vorrichtung (1) nach einem der vorhergehenden Ansprüche, wobei ein Vorrichtungsgehäuse (26) vorgesehen sind, in dem zumindest abschnittsweise der Inspektionskanal (10), wenigstens ein Gehäuse (15) mit der in diesem aufgenommenen Beleuchtungseinheit (13), die wenigstens eine Kamera (14) und/oder die Absaugeinheit (22) aufgenommen sind.

## Claims

1. Device (1) for identifying foreign parts in spinning preparation, having an inspection channel (10) through which a fibre material stream (11) can be guided, wherein
• foreign parts (12) to be identified are present in the fibre material stream (11), for which purpose at least one lighting unit (13) is provided for irradiating light into the inspection channel (10),
• at least one camera (14) is provided, by means of which light generated by the lighting unit (13) and reflected by the foreign part (12) can be detected,
• a closed housing (15) is provided, in which the lighting unit (13) is accommodated in an air-tight manner,
• a liquid cooling unit (16) is provided for cooling the lighting unit (13),
- by means of which heat that develops during operation of the lighting unit (13) can be guided out of the housing (15) by means of a liquid, and
- which has a heat exchanger (18) by means of which a transfer of heat from the liquid to cooling air (19) flowing through the heat exchanger (18) takes place,
• a discharge unit (20) is provided, by means of which the foreign parts (12) can be discharged from the fibre material stream (11),
• a collecting container (21) is provided, in which the foreign parts (12) discharged from the fibre material stream (11) can be collected,
• a suction unit (22) is provided, by means of which the foreign parts (12) can be discharged from the collecting container (21) by means of conveying air (23), and
• the cooling air (19) and the conveying air (23) are brought together, or the cooling air (19) forms the conveying air (23) after it has flowed through the heat exchanger (18).

2. Device (1) according to claim 1, wherein the liquid cooling unit (16) has liquid lines (17) which are guided through a wall of the housing (15).

3. Device (1) according to claim 1 or 2, wherein the suction unit (22) has a suction fan (24) which generates a conveying air stream of the conveying air (23) and a cooling air stream of the cooling air (19).

4. Device (1) according to any one of the preceding claims, wherein the suction unit (22) has a filter (25)
• into which the conveying air (23) and the cooling air (19) are guided and
• in which the foreign parts (12) can be filtered out of the air streams.

5. Device (1) according to any one of the preceding claims, wherein the heat exchanger (18) and the suction unit (22) are in the form of a structural unit.

6. Device (1) according to any one of the preceding claims, wherein
• two lighting units (13) are arranged on each side of the inspection channel (10), and
• on each side the two lighting units (13) are together accommodated in a single housing (15).

7. Device (1) according to any one of the preceding claims, wherein a device housing (26) is provided, in which there are accommodated at least a portion of the inspection channel (10), at least one housing (15) with the lighting unit (13) accommodated therein, the at least one camera (14) and/or the suction unit (22).

## Revendications

1. Dispositif (1) pour la détection de corps étrangers dans la préparation de filature, présentant un canal d'inspection (10) à travers lequel un courant de matière fibreuse (11) peut être guidé, dans lequel
• des corps étrangers (12) à détecter sont présents dans le courant de matière fibreuse (11), pour lequel au moins une unité d'éclairage (13) est prévue pour exposer le canal d'inspection (10) à de la lumière,
• au moins une caméra (14) est prévue, avec laquelle la lumière générée par l'unité d'éclairage (13) et réfléchie par le corps étranger (12) peut être détectée,
• un boîtier fermé (15) est prévu, dans lequel l'unité d'éclairage (13) est logée de manière étanche à l'air,
• une unité de refroidissement par liquide (16) est prévue pour dissiper la chaleur de l'unité d'éclairage (13),
- avec laquelle la chaleur produite pendant le fonctionnement de l'unité d'éclairage (13) peut être évacuée du boîtier (15) au moyen d'un liquide et
- qui présente un échangeur de chaleur (18), au moyen duquel s'effectue un transfert de chaleur du liquide à un air de refroidissement (19) traversant l'échangeur de chaleur (18),
• une unité d'évacuation (20) est prévue, avec laquelle les corps étrangers (12) peuvent être évacués du courant de matière fibreuse (11),
• un récipient collecteur (21) est prévu, dans lequel les corps étrangers (12) évacués du courant de matière fibreuse (11) peuvent être collectés,
• une unité d'aspiration (22) est prévue, avec laquelle les corps étrangers (12) peuvent être déchargés du récipient collecteur (21) au moyen d'un air de transport (23), et
• l'air de refroidissement (19) et l'air de transport (23) sont réunis ou l'air de refroidissement (19) forme l'air de transport (23) après avoir traversé l'échangeur de chaleur (18).

2. Dispositif (1) selon la revendication 1, dans lequel l'unité de refroidissement par liquide (16) présente des conduites de liquide (17) qui sont guidées à travers une paroi du boîtier (15).

3. Dispositif (1) selon la revendication 1 ou 2, dans lequel l'unité d'aspiration (22) présente un ventilateur d'aspiration (24) qui génère un courant d'air de transport de l'air de transport (23) et un courant d'air de refroidissement de l'air de refroidissement (19).

4. Dispositif (1) selon l'une quelconque des revendications précédentes, dans lequel l'unité d'aspiration (22) présente un filtre (25)
• dans lequel l'air de transport (23) et l'air de refroidissement (19) sont guidés et
• dans lequel les corps étrangers (12) peuvent être filtrés hors des courants d'air.

5. Dispositif (1) selon l'une quelconque des revendications précédentes, dans lequel l'échangeur de chaleur (18) et l'unité d'aspiration (22) sont réalisés sous forme d'unité de construction.

6. Dispositif (1) selon l'une quelconque des revendications précédentes, dans lequel
• de chaque côté du canal d'inspection (10) sont agencées deux unités d'éclairage (13) et
• de chaque côté, les deux unités d'éclairage (13) sont logées ensemble dans un boîtier unique (15).

7. Dispositif (1) selon l'une quelconque des revendications précédentes, dans lequel un boîtier de dispositif (26) est prévu, dans lequel sont logés au moins une portion du canal d'inspection (10), au moins un boîtier (15) avec l'unité d'éclairage (13) logée dans celui-ci, l'au moins une caméra (14) et/ou l'unité d'aspiration (22).
